# FASCICULE DE BREVET EUROPEEN

(11) **EP 0 359 609 B1**
(45) Date de publication et mention de la délivrance du brevet: **10.03.1993**
(21) Numéro de dépôt: 89402275.5
(22) Date de dépôt: 11.08.1989
(51) Int. Cl.: H03H 17/06

(54) **Filtre numérique à débit variable pour modulateur de phase**
Digitales Filter mit veränderlicher Geschwindigkeit für Phasenmodulator
Variable rate digital filter for a phase modulator

(30) Priorité: 12.08.1988 FR 8810883
(43) Date de publication de la demande: 21.03.1990
(73) Titulaire: FRANCE TELECOM, 75015 Paris (FR)
(72) Inventeur: Thiriet, Jean-Yves, F-92130 Issy-les-Moulineaux (FR)
(74) Mandataire: Cabinet Martinet & Lapoux

(56) Documents cités:
- FR-A- 2 568 074
- GB-A- 2 122 055
- PATENT ABSTRACTS OF JAPAN, vol. 8, no. 229 (E-273)[1666], 20 octobre 1984: & JP-A-59 110 218

## Description

La présente invention concerne un filtre numérique recevant un signal numérique entrant à débit variable, et plus particulièrement un modulateur numérique de phase contenant un tel filtre. Un tel modulateur est utilisé pour des transmissions numériques à débit variable, par exemple des faisceaux hertziens numériques.

Actuellement dans un modulateur numérique, le filtre numérique ainsi qu'un convertisseur numérique-analogique relié à la sortie du filtre reçoivent un signal d'horloge d'échantillonnage à fréquence variable directement proportionnelle au débit du signal entrant dans un rapport égal à un facteur de suréchantillonnage constant. Le facteur de suréchantillonnage limite le débit maximum qu'est susceptible de présenter le signal entrant ; en effet, plus le facteur de suréchantillonnage est élevé, plus la fréquence d'échantillonnage atteint rapidement la fréquence maximale d'utilisation du convertisseur numérique-analogique.

En outre, le filtre numérique est un filtre de type transversal passe-bas en bande de base. Des moyens de filtrage analogiques et anti-périodiques sont alors nécessaires dans le modulateur, entre la sortie du convertisseur numérique-analogique et l'entrée d'un circuit de modulation de phase à fréquence intermédiaire.

Si le modulateur doit couvrir une large gamme de débits du signal entrant, on doit accepter un compromis entre le débit maximum possible du signal entrant et le nombre de filtres passe-bas analogiques, anti-périodiques et commutables, dans les moyens de filtrage. Un filtre analogique passe-bas ne peut garantir un filtrage suffisant de la périodicité que dans une gamme réduite de débits, la largeur de cette gamme étant directement proportionnelle au facteur de suréchantillonnage constant.

Le but de la présente invention vise à remédier aux inconvénients précités, en fournissant d'une part un filtre numérique dont le facteur de suréchantillonnage s'adapte en continu au débit variable du signal entrant, d'autre part, un modulateur numérique ne comprenant qu'un unique filtre passe-bas anti-périodique et non une batterie de tels filtres qui sont commutables.

A cette fin, un filtre numérique selon l'invention pour filtrer un signal numérique entrant à fréquence binaire variable en un signal numérique sortant de suréchantillonnage, est caractérisé en ce qu'il comprend
des moyens logiques recevant un signal d'horloge ayant la fréquence binaire variable du signal entrant et un facteur de suréchantillonnage FA sensiblement choisi inversement proportionnellement à la fréquence binaire variable pour produire cycliquement FA numéros d'échantillon en réponse à chaque bit du signal entrant, lesdits numéros d'échantillon étant produits au rythme d'une fréquence d'échantillonnage (Fe) sensiblement constante,
plusieurs moyens de mémorisation d'adresses en nombre égal au nombre de facteurs de suréchantillonnage possibles et ayant mémorisé des adresses d'échantillon, l'un desdits moyens de mémorisation d'adresses étant sélectionné par le facteur de suréchantillonnage choisi reçu et étant lu cycliquement par lesdits numéros d'échantillon,
des moyens pour convertir les bits du signal entrant en des mots de symbole respectifs ayant un nombre prédéterminé de bits du signal entrant, et un mot de symboles correspondant à un bit du signal entrant comprenant ce bit et des bits voisins de ce bit dans le signal entrant, et
plusieurs moyens de mémorisation d'échantillons en nombre égal au nombre de mots de symboles possibles et ayant chacun mémorisé des réponses impulsionnelles dudit filtre pour lesdits facteurs de suréchantillonnage possibles, lesdits moyens de mémorisation d'échantillons étant sélectionnés respectivement par lesdits mots de symboles et le moyen de mémorisation d'échantillons sélectionné étant lu par les adresses d'échantillon qui sont lues dans le moyen de mémorisation d'adresses sélectionné par le facteur de suréchantillonnage choisi reçu afin de fournir FA échantillons numériques composant le signal sortant.

En pratique, le facteur de suréchantillonnage choisi est sensiblement inversement proportionnel au débit variable du signal entrant, chaque facteur de suréchantillonnage correspondant à une gamme de débit prédéterminée du signal entrant. La fréquence d'échantillonnage ne varie que très faiblement. Contrairement à la technique antérieure, la limitation de débit due au convertisseur numérique-analogique est beaucoup moins sévère puisque le facteur de suréchantillonnage variable selon l'invention est le plus faible pour les débits élevés du signal entrant.

Un modulateur numérique selon l'invention comprend le filtre numérique selon l'invention, et, en outre, des moyens uniques de filtrage passe-bas analogiques et anti-périodiques reliés en sortie du filtre numérique à travers des moyens de conversion numérique-analogique. Comme on le verra dans la suite dans une réalisation préférée concernant un modulateur numérique, chacune des deux voies parallèles en phase et quadrature dans le modulateur comprend un unique filtre passe-bas anti-périodique. Ce filtre remédie aux inconvénients de réglages et de commutations dans une batterie de filtres selon la technique antérieure.

D'autres avantages et caractéristiques de la présente invention apparaîtront plus clairement à la lecture de la description suivante en référence aux dessins annexés dans lesquels :
- la Fig. 1 est un bloc-diagramme schématique d'un modulateur numérique MDP4 selon l'invention ; et
- la Fig. 2 est un bloc-diagramme détaillé d'un filtre numérique selon l'invention, pour le modulateur de la Fig. 1.

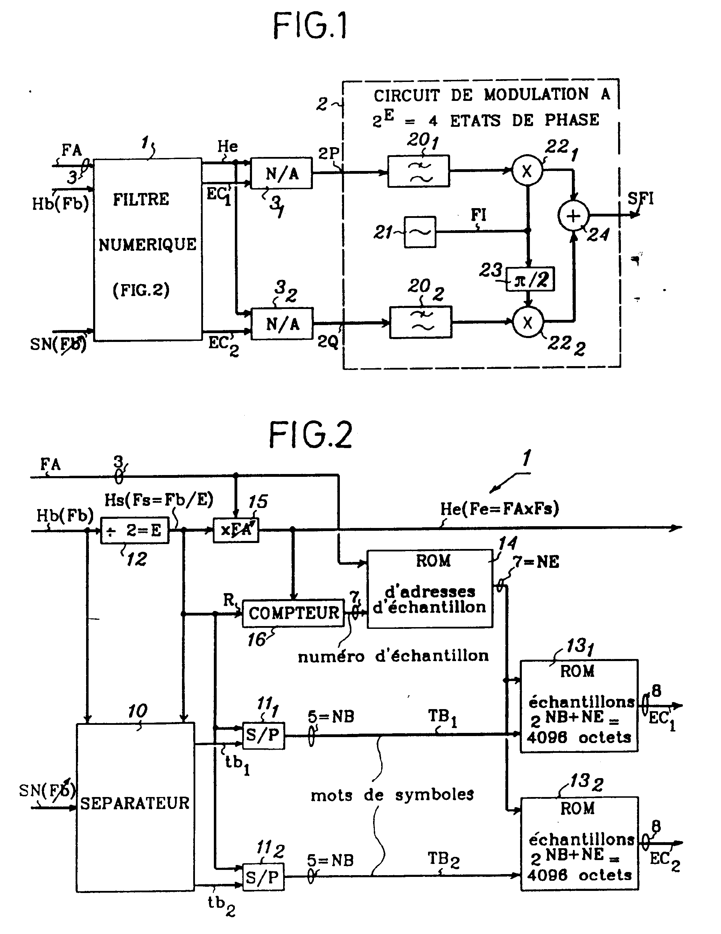

Selon la réalisation illustrée à la Fig. 1, un filtre numérique 1 est destiné à produire deux signaux numériques d'échantillons EC₁ et EC₂ à deux entrées 2P et 2Q d'un circuit de modulation à 2^{E}=4 états de phase (MDP4) 2, à travers deux convertisseurs numériques-analogiques 3₁ et 3₂ respectivement.

En référence à la Fig. 2, le filtre 1 comprend, en entrée, des moyens pour séparer un signal numérique entrant à débit variable SN en bande de base à filtrer et moduler en deux trains binaires pair et impair, TB₁ et TB₂, composés de mots de symbole à bits parallèles. Dans les moyens pour séparer, un séparateur numérique 10 reçoit le signal entrant SN et un signal d'horloge Hb ayant la fréquence binaire variable Fb du signal SN. Le séparateur 10 sépare le signal entrant SN en deux trains binaires série tb₁ et tb₂ composés respectivement des bits de rang impair et des bits de rang pair dans le signal SN, sous le contrôle d'un signal d'horloge de symbole Hs ayant la fréquence Fs=Fb/E=Fb/2. Un bit du train tb₁ et un bit du train tb₂, qui succède audit bit du train tb₁ dans le signal SN, constitue un symbole à deux groupes parallèles ayant E/2 bits chacun. Le signal Hs est délivré par un diviseur de fréquence par deux 12 divisant par E=2 la fréquence Fb du signal d'horloge de bit Hb. Les moyens pour séparer comportent également deux convertisseurs série-parallèle 11₁ et 11₂ pour convertir les deux trains binaires série tb₁ et tb₂ en les deux trains binaires à mots de symboles TB₁ et TB₂ respectivement. Chaque symbole correspondant à E=2 bits consécutifs dans le signal entrant SN est ainsi converti en deux mots de symboles parallèles respectivement dans les trains TB₁ et TB₂. Un mot de symboles dans le train TB₁, TB₂ comprend NB=5 bits. Pour une réponse symétrique selon la réalisation illustrée, ledit mot de symboles comprend comme bit central, le bit correspondant du train respectif tb₁, tb₂, et les deux bits précédant ledit bit central dans le train tb₁, tb₂ et les deux bits succédant audit bit central dans le train tb₁, tb₂. Les convertisseurs 11₁ et 11₂ comprennent donc chacun un registre à décalage à NB=5 étages commandés par le signal d'horloge de symbole Hs.

La réponse impulsionnelle du filtre 1 s'étendant sur des mots de symboles à NB=5 bits dans les trains TB₁ et TB₂ est préalablement enregistrée dans deux mémoires mortes PROM d'échantillons respectives 13₁ et 13₂. Chaque mot de symboles peut être suréchantillonné en au plus 2^{NE}=2⁷=128 mots d'échantillons dans le signal numérique d'échantillon respectif EC₁, EC₂. Chaque mot d'échantillon comprend 8 bits selon la réalisation illustrée. Il en résulte que chacune des mémoires 13₁ et 13₂ contient 2^{NE}x2^{NB}=2⁷x2⁵=4096 octets d'échantillons, répartis en 2^{NB}=2⁵=32 sous-mémoires d'échantillons respectivement assignées aux 32 mots de symboles possibles. Chacune des sous-mémoires dans la mémoire 13₁, 13₂ est adressée par un mot de symboles à 5 bits du train respectif TB₁, TB₂, et chacun des mots d'échantillon dans une sous-mémoire est addressé par une adresse d'échantillon à NE=7 bits, qui est lue dans une mémoire morte PROM d'adresses d'échantillon 14. En d'autres termes, une adresse totale d'un mot d'échantillon est composée d'une première partie à NB=5 bits de poids fort égale au mot de symboles à suréchantillonner dans le train TB₁, TB₂, et d'une seconde partie à NE=7 bits de poids faible égale à l'adresse d'échantillon dans la sous-mémoire assignée au symbole.

La mémoire morte d'adresses d'échantillon 14 est composée de sous-mémoires d'adresses en nombre égal au nombre de facteurs de suréchantillonnage possibles. La sous-mémoire d'adresses correspondant à un facteur de suréchantillonnage donné est lue cycliquement pour chaque paire de mots de symbole parallèles dans les trains TB₁ et TB₂.

Selon la réalisation illustrée, un facteur de suréchantillonnage FA parmi NFA=8 possibles est reçu sous la forme d'un mot codé à 3=log₂8 bits parallèles à une troisième entrée du filtre 1. Ce facteur codé est appliqué à une première entrée d'adresse de lecture de la mémoire d'adresses 14 et à une entrée de décodage d'un circuit de multiplication de fréquence programmable 15. Une entrée d'horloge du circuit 15 reçoit le signal d'horloge de symbole Hs. Une sortie du circuit 15 produit un signal d'horloge d'échantillonnage He ayant la fréquence Fe=FAxFs qui est appliqué à des entrées d'horloge d'un compteur à 8 bits 16 et des convertisseurs numériques-analogiques 3₁ et 3₂. Le compteur 16 reçoit le signal d'horloge Hs par une entrée de remise à zéro R afin de fournir cycliquement FA numéros d'échantillons à NE=7 bits en réponse à chaque front montant du signal Hs. Les numéros d'échantillon sont appliqués à une seconde entrée d'adresse de lecture de la mémoire d'adresses d'échantillon 14 et sélectionnent des adresses d'échantillon contenues dans la sous-mémoire d'adresses de la mémoire 14 qui est adressée par le facteur codé FA appliqué à la première entrée de la mémoire 14.

Ainsi, pour chaque groupe à E/2=1 bit dans le train binaire-série tb₁, tb₂ correspondant à un cycle égal à la période du signal d'horloge de symbole Hs, FA adresses d'échantillon sélectionnées dans la mémoire 14 sont lues par le compteur 16 afin de lire FA échantillons numériques composant le signal EC₁, EC₂ dans la sous-mémoire respective de la mémoire 13₁, 13₂ qui est sélectionnée par le mot de symboles à NB=5 bits dans le train respectif TB₁, TB₂. L'ensemble des échantillons de cette sous-mémoire représente la réponse impulsionnelle du filtre pour le facteur de suréchantillonnage choisi FA et pour le mot de symboles.

En pratique, le paramètre à 3 bits représentant sous forme codée le facteur FA est établi par un circuit de sélection de facteurs de suréchantillonnage qui choisit le facteur de suréchantillonnage correspondant au débit instantané Fb du signal entrant SN par comparaison aux limites de gammes discrètes de débits. Par exemple, si le débit du signal SN varie de 0 à 13,33 Mbits/s, le facteur de suréchantillonnage FA est choisi parmi les valeurs 68, 25, 11, 4, 6 et 3 qui sont codées respectivement en des facteurs codés binaires "000", "001", "010", "011", "100" et "101" et qui correspondent respectivement aux gammes de débit du signal SN suivantes : (0 ; 588 kbit/s), (588 kbit/s ; 1,6 Mbit/s), (1,6 Mbit/s ; 3,64 Mbit/s), (3,64 Mbit/s ; 6,66 Mbit/s), (6,66 Mbit/s ; 10 Mbit/s) et (10 Mbit/s ; 13,33 Mbit/s). Dans ce cas, la fréquence maximum des convertisseurs numériques-analogiques est égale à 3x(13,33/2)=20 MHz.

En se référant à nouveau à la Fig. 1, les mots d'échantillons à 8 bits EC₁ et EC₂ sont convertis par les convertisseurs 3₁ et 3₂ en des échantillons analogiques qui sont appliqués respectivement aux entrées uniquement de deux filtres analogiques passe-bas anti-périodiques 20₁ et 20₂ dans le circuit de modulation 2. Chaque filtre 20₁, 20₂ est un filtre de Butterworth d'ordre 5 de bande de 5,85 MHz à 3 dB pour la réalisation pratique précitée.

Le circuit de modulation à quatre états de phase comprend classiquement un oscillateur local 21 produisant une porteuse à fréquence intermédiaire prédéterminée FI, et deux modulateurs de phase 22₁, 22₂ respectivement associés aux deux axes de phase en quadrature. Le premier modulateur 22₁ reçoit le premier signal analogique d'échantillon sortant du filtre 20₁, comme signal modulant, et, la porteuse en avance de phase pour produire un premier signal modulé à deux états de phase O et π. Le second modulateur 22₂ reçoit le second signal analogique d'échantillon sortant du filtre 20₂, comme signal modulant, et à travers un déphaseur de π/2,23, la porteuse de l'oscillateur 21 pour produire un second signal modulé à deux états de phase π/2 et 3π/2. Un mélangeur 24 mélange les deux signaux modulés en un signal sortant modulé à quatre états de phase SFI.

Bien que l'invention ait été décrite en référence à un modulateur à quatre états de phase, d'autres réalisations de modulateurs numériques comprenant un filtre numérique ayant des caractéristiques définies ci-après peuvent être conçues par l'homme du métier. Ainsi, le modulateur peut être un modulateur à 2^{E} états de phase où E est un entier égal ou supérieur à 1 ; en particulier, le filtre 1 contient toujours deux convertisseurs série-parallèle et deux mémoires PROM d'échantillon, et les mots de symboles sont d'autant plus longs que le nombre E est grand. Par exemple, pour 2^{E}=16 états de phase, chaque symbole correspond à E=4 bits consécutifs dans le signal entrant SN, et à un groupe de bits pairs et un groupe de bits impairs dans les trains tb₁ et tb₂ ayant chacun E/2=2 bits, et à deux mots de symboles dans les trains TB₁ et TB₂ ayant chacun 5xE/2=10 bits.

Un tel filtre numérique peut être utilisé dans un modulateur à sauts de fréquence, par analogie au modulateur à sauts de phase.

## Revendications

1. Filtre numérique (1) pour filtrer un signal numérique entrant (SN) à fréquence binaire variable (Fb) en un signal numérique sortant de suréchantillonnage (EC), caractérisé en ce qu'il comprend
des moyens logiques (12, 15, 16) recevant un signal d'horloge ayant la fréquence binaire variable (Fb) du signal entrant (SN) et un facteur de suréchantillonnage FA sensiblement choisi inversement proportionnellement à la fréquence binaire variable (Fb) pour produire cycliquement FA numéros d'échantillon en réponse à chaque bit du signal entrant, lesdits numéros d'échantillon étant produits au rythme d'une fréquence d'échantillonnage (Fe) sensiblement constante,
plusieurs moyens de mémorisation d'adresses (14) en nombre égal au nombre (NFA) de facteurs de suréchantillonnage possibles et ayant mémorisé des adresses d'échantillon, l'un desdits moyens de mémorisation d'adresses étant sélectionné par le facteur de suréchantillonnage choisi reçu (FA) et étant lu cycliquement par lesdits numéros d'échantillon,
des moyens (10, 11) pour convertir les bits du signal entrant (SN) en des mots de symboles respectifs (TB) ayant un nombre prédéterminé (NB) de bits du signal entrant (SN), un mot de symboles correspondant à un bit du signal entrant comprenant ce bit et des bits voisins de ce bit dans le signal entrant, et
plusieurs moyens de mémorisation d'échantillons (13) en nombre égal au nombre (2^{NB}) de mots de symboles possibles et ayant chacun mémorisé des réponses impulsionnelles dudit filtre pour lesdits facteurs de suréchantillonnage possibles, lesdits moyens de mémorisation d'échantillons étant sélectionnés respectivement par lesdits mots de symboles, et le moyen de mémorisation d'échantillons sélectionné étant lu par les adresses d'échantillon qui sont lues dans le moyen de mémorisation d'adresses sélectionné par le facteur de suréchantillonnage choisi reçu afin de fournir FA échantillons numériques composant le signal sortant (EC).

2. Filtre numérique conforme à la revendication 1, caractérisé en ce que les moyens logiques comprennent des moyens (12, 15) pour multiplier la fréquence binaire variable (Fb) du signal entrant (SN) par le facteur de suréchantillonnage choisi FA, de préférence reçu sous forme codée, en ladite fréquence d'échantillonnage (Fb), et des moyens de comptage (16) pour produire les FA numéros d'échantillon au rythme de la fréquence d'échantillonnage (Fb) et cycliquement à la fréquence binaire (Fb).

3. Modulateur numérique caractérisé en ce qu'il comprend un filtre numérique (1) conforme à la revendication 1 ou 2, et, en outre, des moyens uniques de filtrage passe-bas anti-périodiques (20) reliés en sortie du filtre (1) à travers des moyens de conversion numérique-analogique (3).

4. Modulateur numérique à 2^{E} états de phase, où E est un entier égal ou supérieur à 1, comprenant un filtre numérique (1), des moyens (3₁, 3₂) pour convertir des paires d'échantillons numériques parallèles (E₁, E₂) fournis par le filtre en deux signaux analogiques (2Q, 2P), et des moyens (2) pour moduler une porteuse (FI) par les deux signaux analogiques en un signal modulé (SFI) à 2^{E} états de phase, caractérisé en ce que le filtre numérique est conforme à la revendication 1 ou 2.

5. Modulateur conforme à la revendication 4, caractérisé en ce que chacun des deux signaux analogiques (2P, 2Q) est appliqué aux moyens pour moduler (2) à travers un unique filtre passe-bas analogique anti-périodique (20₁, 20₂).

6. Modulateur conforme à la revendication 4 ou 5, caractérisé en ce que ledit filtre numérique (1) comprend des moyens (10, 11₁, 11₂) pour séparer le signal numérique entrant (SN) en deux trains parallèles de mots de symboles, chaque paire de mots de symboles parallèles correspondant à E bits consécutifs du signal entrant, et en ce que lesdits plusieurs moyens de mémorisation d'échantillons comprennent deux mémoires identiques d'échantillons (13₁, 13₂) adressées respectivement en lecture par des premières parties d'adresse égales aux deux mots de symboles parallèles et simultanément en lecture par des secondes parties d'adresse communes égales aux adresses lues dans le moyen de mémorisation d'adresses (14) sélectionné par le facteur de suréchantillonnage choisi reçu FA, lesdites mémoires étant reliées aux moyens pour convertir (3₁, 3₂), et
en ce que les moyens pour convertir reçoivent des moyens logiques (12, 15, 16) une fréquence d'horloge d'échantillonnage (Fe) égale au produit de la fréquence binaire (Fb) par FA/E.

## Patentansprüche

1. Digitales Filter (1) zum Filtern eines eintreffenden digitalen Signals (SN) mit einer binären veränderlichen Frequenz (Fb) in ein abgehendes digitales, überabgetastetes Signal (EC), dadurch gekennzeichnet, daß es
logische Einrichtungen (12, 15, 16), die ein Zeitsignal mit der binären veränderlichen Frequenz (Fb) des eintreffenden Signals (SN) und einen Überabtastfaktor FA, der genau umgekehrt proportional zur binären veränderlichen Frequenz (Fb) gewählt wird, empfangen, um zyklisch FA Abtastwerte als Antwort auf jedes Bit des eintreffenden Signals zu erzeugen, wobei die Abtastwerte im Rhythmus einer konstanten Abtastfrequenz (Fe) erzeugt werden,
mehrere Einrichtungen zur Adreßspeicherung (14) in einer Zahl, die der Zahl (NFA) der möglichen Überabtastfaktoren entspricht, die Abtastadressen gespeichert haben, wobei eine der Einrichtungen zur Adreßspeicherung von dem ausgewählten und empfangenen Überabtastfaktor (FA) ausgewählt und zyklisch von den Abtastwerten gelesen wird,
Einrichtungen (10, 11) zum Umwandeln der Bits des eintreffenden Signals (SN) in Symbolworte (TB) mit einer vorgegebenen Zahl (NB) von Bits des eintreffenden Signals (SN), wobei das Symbolwort, das einem Bit des eintreffenden Signals entspricht, dieses Bit und Nachbarbits dieses Bits im eintreffenden Signal enthält, und
mehrere Einrichtungen zur Speicherung von Abtastwerten (13) in einer Zahl, die der Zahl (2^{NB}) der möglichen Symbolworte entspricht, die jede Impulsantworten des Filters für die möglichen Überabtastfaktoren gespeichert haben, wobei die Einrichtungen zur Speicherung von Abtastwerten jeweils von den Symbolworten ausgewählt werden, und die ausgewählte Einrichtung zum Speichern von Abtastwerten von Abtastadressen gelesen wird, die in die Einrichtung zur Speicherung von Adressen gelesen werden, die von dem ausgewählten und empfangenen Überabtastfaktor ausgewählt wurde, um FA digitale Abtastwerte zu liefern, die das Ausgangssignal (EC) bilden, aufweist.

2. Digitales Filter nach Anspruch 1, dadurch gekennzeichnet, daß die logischen Einrichtungen Einrichtungen (12, 15) zur Multiplikation der binären veränderlichen Frequenz (Fb) des eintreffenden Signals (SN) mit dem gewählten Überabtastfaktor FA, der vorzugsweise in kodierter Form in der Abtastfrequenz (Fb) empfangen wird, und Einrichtungen zum Zählen (16) aufweisen, um die FA Abtastwerte im Rhythmus der Abtastfrequenz (Fb) und zyklisch mit der binären Frequenz (Fb) zu erzeugen.

3. Digitaler Modulator, dadurch gekennzeichnet, daß er ein digitales Filter (1) nach Anspruch 1 oder 2 und außerdem eine einzige Einrichtung zur nichtperiodischen Tiefpaßfilterung (20), die mit dem Ausgang des Filters (1) über Einrichtungen zur Digital-Analog-Wandlung (3) verbunden ist, aufweist.

4. Digitaler Modulator mit 2^{E} Phasenzuständen, wobei E eine ganze Zahl gleich oder größer 1 ist, der ein digitales Filter (1), Einrichtungen (3₁, 3₂) zum Umwandeln von Paaren von parallelen, digitalen, von dem Filter gelieferten Abtastwerten (E₁, E₂), in zwei analoge Signale (2Q,2P), und Einrichtungen (2) zur Modulation eines Trägers (FI) mit den beiden analogen Signalen in ein moduliertes Signal (SFI) mit 2^{E} Phasenzuständen aufweist, dadurch gekennzeichnet, daß das digitale Filter Anspruch 1 oder 2 entspricht.

5. Modulator nach Anspruch 4, dadurch gekennzeichnet, daß jedes der beiden analogen Signale (2P, 2Q) auf die Einrichtungen zur Modulation (2) über ein einziges nichtperiodisches analoges Tiefpaßfilter (20₁, 20₂) gegeben wird.

6. Modulator nach Anspruch 4 oder 5, dadurch gekennzeichnet, daß das digitale Filter (1) Einrichtungen (10, 11₁, 11₂) zum Trennen des eintreffenden digitalen Signals (SN) in zwei parallele Stränge von Symbolworten aufweist, wobei jedes Paar von parallelen Symbolworten E aufeinanderfolgenden Bits des eintreffenden Signals entspricht, und dadurch, daß die mehreren Einrichtungen zur Speicherung von Abtastwerten zwei identische Speicher für Abtastwerte (13₁, 13₂) aufweisen, die jeweils beim Lesen von den ersten Teilen der Adresse, die den beiden parallelen Symbolworten entsprechen und gleichzeitig beim Lesen von den beiden gemeinsamen Teilen der Adresse, die der von der Einrichtung zur Speicherung der Adresse (14), die vom empfangenen, ausgewählten Überabtastfaktor FA ausgewählt worden ist, adressiert werden, wobei die Speicher mit den Einrichtungen zum Umwandeln (3₁, 3₂) verbunden sind, und dadurch, daß die Einrichtungen zum Umwandeln von den logischen Einrichtungen (12, 15, 16) eine Frequenz eines Abtastzeitsignals (Fe), die gleich ist dem Produkt der binären Frequenz (Fb) mit FA/E, empfangen.

## Claims

1. A digital filter (1) whereby a digital signal (SN) arriving at a variable binary frequency (Fb) is filtered into an outgoing super-sampling digital signal (EC), the filter being characterised in that it comprises
logic means (12, 15, 16) receiving a clock signal having the variable binary frequency (Fb) of the incoming signal (SN) and a super-sampling factor FA chosen so so as to be substantially inversely proportional to the variable binary frequency (Fb) in order cyclically to produce FA sample numbers in response to each bit of the incoming signal, the sample numbers being produced at a substantially constant sampling frequency (Fe),
a number of address-storing means (14) equal to the number (NFA) of possible super-sampling factors and storing sample addresses, one of the address storage means being selected by the received chosen super-sampling factor (FA) and being cyclically read by the sampling numbers,
means (10, 11) for converting the bits in the incoming signal (SN) into respective symbol words (TB) having a predetermined number (NB) of bits of the incoming signal (SN), a symbol word corresponding to a bit of the incoming signal comprising this bit and bits adjacent this bit in the incoming signal, and
a number of sample storage means (13) equal to the number (2^{NB}) of possible symbol words and each storing pulse responses of the filter for the aforementioned possible super-sampling factors, the sample storage means being respectively selected by the symbol words, and the selected sample storage means being read by the sample addresses which are read in the address storage means selected by the received chosen super-sampling factor in order to supply FA digital samples making up the outgoing signal (EC).

2. A digital filter according to claim 1, characterised in that the logic means comprise means (12, 15) for multiplying the variable binary frequency (Fb) of the incoming signal (SN) by the chosen super-sampling factor (FA), preferably received in code form, in the aforementioned sampling frequency (Fb), and counting means (16) for producing the FA sample numbers at the sampling frequency (Fb) and cyclically at the binary frequency (Fb).

3. A digital modulator characterised in that it comprises a digital filter (1) according to claim 1 or 2 and also comprises single anti-periodic low-pass filtering means (20) connected to the output of the filter (1) via digital-analog conversion means (3).

4. A digital modulator having 2^{E} phase states, where E is an integer equal to or greater than 1, comprising a digital filter (1), means (3₁, 3₂) for converting pairs of parallel digital samples (E₁. E₂) supplied by the filter into two analog signals (2Q, 2P), and means (2) for modulating a carrier wave (FI) by the two analog signals so as to convert it into a modulated signal (SFI) having 2^{E} phase states, characterised in that the digital filter is as per claim 1 or 2.

5. A modulator according to claim 4, characterised in that each of the two analog signals (2P, 2Q) is applied to the modulating means (2) via a single anti-periodic analog low-pass filter (20₁, 20₂).

6. A modulator according to claim 4 or 5, characterised in that the digital filter (1) comprises means (10, 11₁, 11₂) for separating the incoming digital signal (SN) into two parallel trains of symbol words, each pair of parallel symbol words corresponding to E consecutive bits of the incoming signal, and the aforementioned number of sample storage means comprise two identical sample stores (13₁, 13₂) respectively addressed for read-out by first address parts equal to the two parallel symbol words and simultaneously for read-out by second common address parts equal to the addresses read in the address storage means (14) selected by the received chosen super-sampling factor FA, the memories being connected to the converting means (C₁, C₂), and
the converting means are supplied by the logic means (12, 15, 16) with a sampling clock frequency (Fe) equal to the product of the binary frequency (Fb) and FA/E.
